# DEMANDE DE BREVET EUROPEEN

(11) **EP 1 091 512 A1**
(43) Date de publication de la demande: **11.04.2001**
(21) Numéro de dépôt: 99119744.3
(22) Date de dépôt: 06.10.1999
(51) Int. Cl.: H04H 1/00, H04B 1/30

(54) **Récepteur à modulation de fréquence, notamment pour une application RDS**

(71) Demandeur: Conseils et Manufactures VLG SA, 2008 Neuchâtel (CH)
(72) Inventeur: Gerrits, John F.M., CH-2016 Cortaillod (FR)
(74) Mandataire: Ravenel, Thierry Gérard Louis

(57) **Abrégé**

La présente invention concerne un récepteur (29) à modulation de fréquence comprenant : une antenne (2) pouvant recevoir d'un émetteur un signal à une fréquence élevée; un étage à haute fréquence (3); un oscillateur (5); un bloc mélangeur (30) pouvant fournir un signal (S6) à une fréquence intermédiaire (f_{IF}); un étage de démodulation (8); et un étage de commande automatique de fréquence (36) pouvant commander à l'oscillateur, de manière à maintenir constante ladite fréquence intermédiaire dudit cinquième signal. Ce récepteur comprend en outre une boucle de verrouillage (32) agencée pour asservir la fréquence intermédiaire (f_{IF}) à partir d'une fréquence pilote (fp) présente dans le signal démodulé. Un avantage d'une telle boucle de verrouillage est d'asservir la fréquence intermédiaire de sorte que le phénomène de repliement de spectre n'empêche pas la démodulation des signaux contenant les données RDS.

## Description

La présente invention concerne le domaine des récepteurs à modulation de fréquence (FM) pouvant recevoir d'un émetteur un signal à une fréquence élevée, notamment pour une application RDS (acronyme provenant de l'anglais « Radio Data System »).

En se référant à la figure 1 de la présente description, le document FR 2705.176 décrit un récepteur FM classique 1 qui comprend une antenne 2, un étage à haute fréquence (RF) 3, un mélangeur 4, un oscillateur local 5, un filtre à fréquence intermédiaire (IF) 6, un amplificateur/limiteur 7, un étage de démodulation FM 8 et un étage de commande automatique de fréquence (AFC) 9.

L'antenne 2 reçoit un signal ayant une fréquence comprise dans la bande FM de transmission (c'est-à-dire entre 88 et 108 Mhz), et fournit le signal électrique correspondant à l'étage RF 3.

L'étage RF 3 est accordé sur la fréquence porteuse fc d'un émetteur prédéterminé de manière à fournir, en réponse au signal électrique provenant de l'antenne, un signal amplifié ayant une fréquence comprise dans une bande de fréquence centrée sur la fréquence fc.

Le mélangeur 4 reçoit le signal provenant de l'étage RF 3, ainsi qu'un signal provenant de l'oscillateur local 5, multiplie ces signaux, et fournit au filtre _{IF} 6 un signal modulé à une fréquence intermédiaire f_{IF}, cette dernière étant généralement choisie égale à 70 kHz environ.

Le filtre IF 6 est agencé pour recevoir le signal modulé à la fréquence f_{IF} et, en réponse, fournir un signal situé dans une bande de fréquence centrée autour de la fréquence intermédiaire f_{IF}.

L'amplificateur/limiteur 7 reçoit le signal provenant du filtre IF 6, limite son amplitude pour en éliminer toute composante en modulation d'amplitude AM et, en réponse, fournit ce signal amplifié/limité.

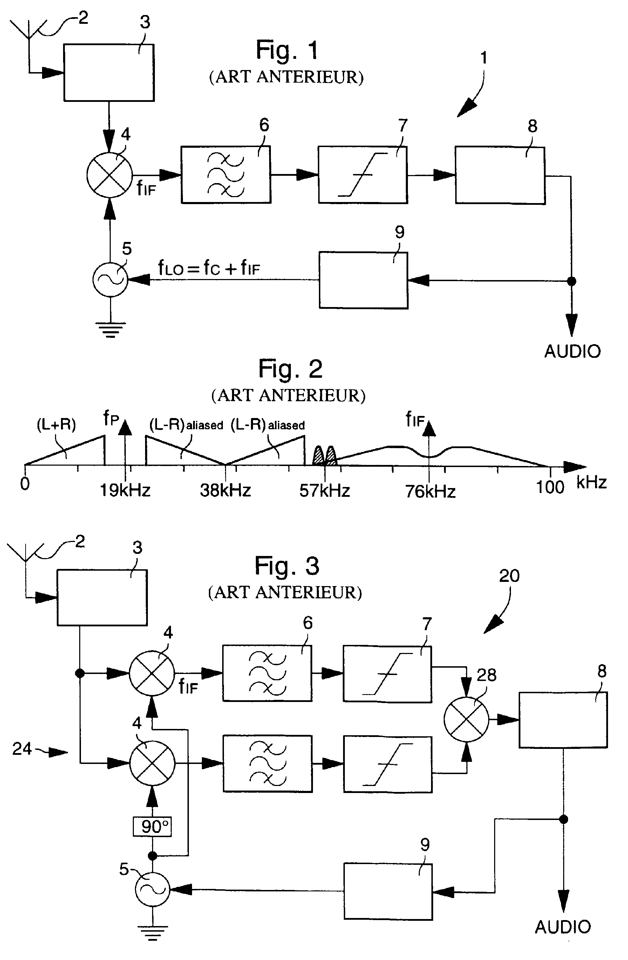

L'étage de démodulation FM 8 démodule le signal provenant de l'amplificateur/limiteur 7, et fournit le signal démodulé vers un amplificateur audio (non représenté en figure 1).

L'étage AFC 9 permet d'opérer un accord fin entre la fréquence f_{LO} du signal de l'oscillateur local 5 en fonction de la sortie continue du démodulateur 8, afin de maintenir constante la fréquence intermédiaire f_{IF}.

Un problème d'un récepteur radio FM tel que celui représenté en figure 1 consiste en ce qu'une distorsion considérable peut apparaître par repliement de spectre, quand la fréquence de modulation (c'est-à-dire celle du signal de message) est supérieure à la moitié de la fréquence intermédiaire f_{IF}. Ce phénomène de repliement est communément appelé par le terme anglais « aliasing ».

Le problème de distorsion par repliement de spectre se pose surtout dans des systèmes de transmission utilisant le multiplexage par division de fréquence, comme cela est le cas en Europe avec la radiodiffusion en FM, en particulier pour une application RDS. En effet, une telle distorsion peut avoir comme effet que le décodage des données RDS devient impossible.

La figure 2 de la présente description représente la répartition spectrale en fréquence des signaux présents dans le récepteur FM 1, lors d'une application RDS. Des données audio sont modulées en stéréophonie sur une sous-porteuse de 38 kHz, tandis que d'autres données correspondant aux données RDS sont présentes sous forme de signaux à faible amplitude et modulées sur une sous-porteuse de 57 kHz par décalage de phase (modulation PSK). Pour permettre le décodage des données RDS, et en se référant à nouveau à la figure 1, la largeur de bande de sortie de l'étage de démodulation FM 8 devrait être d'au moins 60 kHz. En effet, en supposant que la fréquence intermédiaire f_{IF} utilisée est de l'ordre de 70 Khz, les données audio et les données RDS peuvent se mélanger par repliement de spectre.

Une première solution classique au problème de repliement de spectre de fréquences consiste à utiliser une fréquence f_{IF} plus élevée. Le brevet US 4.885.802 décrit un récepteur FM mettant en oeuvre une telle solution.

Un inconvénient d'un tel récepteur FM réside dans le fait qu'il nécessite le recours à des moyens supplémentaires pour filtrer la réponse de la fréquence image du signal RF, ce qui augmente également la consommation en puissance électrique.

Un autre inconvénient d'un tel récepteur FM réside dans le fait que la fréquence intermédiaire maximale utilisable est imposée par le rejet de la fréquence-image et par l'espacement des canaux ou émetteurs dans la bande de diffusion FM. Par conséquent, la largeur de bande audio des signaux démodulés ne peut donc être améliorée simplement par une augmentation de la fréquence intermédiaire f_{IF} du récepteur FM.

Une deuxième solution classique au problème de repliement de spectre de fréquences consiste à fournir à l'étage de démodulation un signal ayant une fréquence plus élevée que la fréquence intermédiaire f_{IF}.

En se référant à la figure 3 de la présente description, le brevet US 5.483.695 décrit un récepteur FM 20 mettant en oeuvre une telle solution. On note en figure 3 que des objets similaires à ceux de la figure 1 ont été désignés par les mêmes références. Le récepteur FM 20 comprend en outre un circuit générateur de signaux 24 pouvant générer n signaux à la fréquence intermédiaire f_{IF}, et un circuit multiplicateur 28 pouvant multiplier entre eux ces n signaux pour fournir un signal modulé à une fréquence égale à n fois la fréquence intermédiaire f_{IF}.

Un inconvénient du récepteur FM 20 réside dans le fait qu'il est nécessaire de générer des signaux en quadrature de phase, et ayant une fréquence égale à la fréquence intermédiaire f_{IF}, ce qui augmente considérablement la consommation en puissance électrique.

Un objet de la présente invention est de prévoir un récepteur radio FM pour une application RDS remédiant au problème de repliement du spectre, notamment un récepteur radio FM pouvant extraire les données RDS présentes dans un signal radiofréquence reçu par ce récepteur.

Un autre objet de la présente invention est de prévoir un récepteur radio FM répondant au critère habituel dans l'industrie de faible consommation en puissance électrique.

Un autre objet de la présente invention est de prévoir un récepteur radio FM sous la forme d'un circuit intégré répondant au critère habituel dans l'industrie des semi-conducteurs de rationalité et de surface d'occupation.

Ces objets ainsi que d'autres sont atteints par le récepteur FM selon la revendication 1.

Un avantage de l'agencement de la boucle de verrouillage d'un tel récepteur est d'asservir la fréquence intermédiaire f_{IF} à une valeur prédéterminée de sorte que le phénomène de repliement de spectre n'empêche pas le décodage des données RDS présentes dans un signal radiofréquence reçu par le récepteur.

Un autre avantage d'un tel agencement est que le récepteur peut fonctionner avec des fréquences intermédiaires f_{IF} peu élevées, sans qu'il soit nécessaire de recourir à des valeurs élevées de fréquence, ni à une multiplication de fréquence. Il en résulte une faible consommation de puissance électrique, ce qui permet d'utiliser un récepteur FM de ce type pour une application RDS par exemple.

Ces objets, caractéristiques et avantages ainsi que d'autres de la présente invention apparaîtront plus clairement à la lecture de la description détaillée d'un mode de réalisation préféré de l'invention, donnés à titre d'exemple uniquement, en relation avec les figures jointes parmi lesquelles :
- la figure 1 déjà citée représente un premier récepteur FM classique;
- la figure 2 déjà citée représente la répartition spectrale en fréquence des signaux présents dans le récepteur FM de la figure 1, lors d'une application RDS;
- la figure 3 déjà citée représente un deuxième récepteur FM classique;
- la figure 4 représente un mode de réalisation préféré d'un récepteur FM selon la présente invention;
- la figure 5 représente de façon détaillée un circuit du récepteur FM de la figure 4;
- la figure 6 représente de façon détaillée un autre circuit du récepteur FM de la figure 4;
- les figures 7A à 7C représentent les répartitions spectrales en fréquence de signaux présents dans le récepteur FM de la figure 4, lors d'une application RDS, pour trois valeurs prédéterminées différentes, respectivement; et
- la figure 8 représente un perfectionnement du circuit de la figure 6.

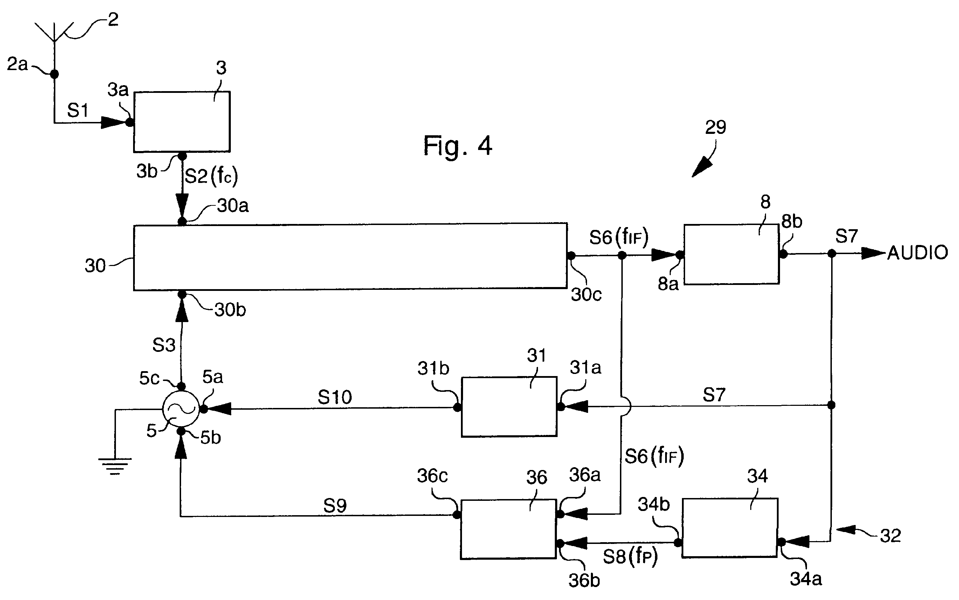

En se référant à la figure 4, on va décrire un mode de réalisation préféré d'un récepteur à modulation de fréquence (FM) selon la présente invention. On notera en figure 4 que la référence 29 désigne un tel récepteur, et que des objets similaires à ceux de la figure 1 ont été désignés par les mêmes références.

Le récepteur FM 29 comprend une antenne 2, un oscillateur local 5, un bloc mélangeur 30, un étage de démodulation 8 et un étage de commande automatique de fréquence (AFC) 36. On notera qu'un tel récepteur est propre à être réalisé dans un dispositif nécessitant la fourniture de données RDS, par exemple dans une pièce d'horlogerie telle qu'une montre-bracelet.

L'antenne 2 comprend une borne de sortie 2a connectée à l'étage RF 3. L'antenne 2 est agencée pour pouvoir recevoir un signal ayant une fréquence comprise dans la bande FM de transmission (c'est-à-dire entre 88 et 108 Mhz) et, en réponse, fournir par la borne 2a un signal électrique S1 représentatif du signal reçu.

L'oscillateur local 5 comprend deux bornes d'entrée 5a et 5b et une borne de sortie 5c connectée au bloc mélangeur 30. L'oscillateur local 5 est agencé pour fournir un signal électrique S3, comme cela est décrit de façon plus détaillée ci-après.

Le bloc mélangeur 30 comprend une borne d'entrée 30a connectée à la borne de sortie 3b de l'étage RF 3, une borne d'entrée 30b connectée à la borne de sortie 5c de l'oscillateur local 5, et une borne de sortie 30c connectée à l'étage de démodulation 8. Le bloc mélangeur 30 est agencé pour fournir, en réponse aux signaux S2 et S3, un signal électrique S6 à une fréquence intermédiaire f_{IF}.

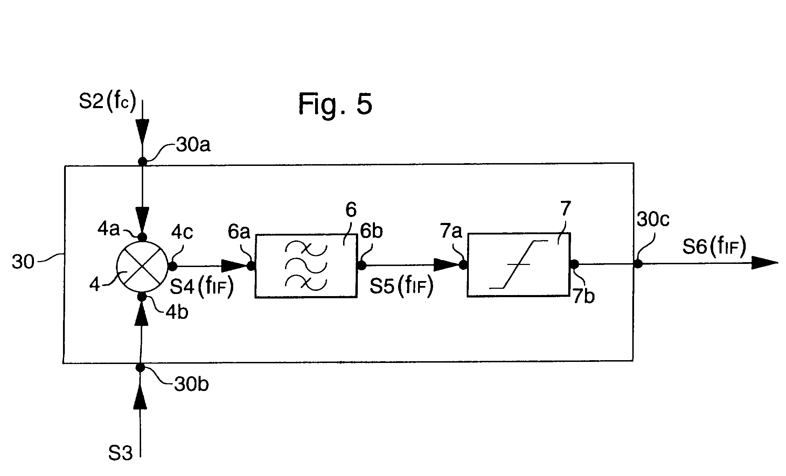

De préférence, on réalise le bloc mélangeur 30 en connectant en série un mélangeur 4, un filtre IF 6 et un amplificateur/limiteur 7, comme le représente la figure 5.

Le mélangeur 4 comprend deux bornes d'entrée 4a et 4b connectées aux bornes respectives 30a et 30b du bloc mélangeur 30, et une borne de sortie 4c connectée au filtre IF 6. Le mélangeur 4 est agencé pour pouvoir : recevoir par la borne 4a le signal S2 et par la borne 4b le signal électrique S3; multiplier les signaux S2 et S3 entre eux; et fournir par la borne 4c un signal électrique S4 de sorte que ce dernier est modulé à la fréquence intermédiaire f_{IF}. A titre d'exemple, la fréquence intermédiaire f_{IF} est choisie égale à 70 kHz environ.

Le filtre IF 6 comprend une borne d'entrée 6a connectée à la borne de sortie 4c du mélangeur 4, et une borne de sortie 6b connectée à l'amplificateur/limiteur 7. Le filtre IF 6 est agencé pour pouvoir recevoir par la borne 6a le signal S4 et, en réponse, fournir un signal électrique S5 situé dans une bande de fréquence centrée autour de la fréquence intermédiaire f_{IF}.

L'amplificateur/limiteur 7 comprend une borne d'entrée 7a connectée à la borne de sortie 6b du filtre IF 6, et une borne de sortie 7b connectée à la borne de sortie 30c du bloc mélangeur 30. L'amplificateur/limiteur 7 est agencé pour pouvoir recevoir par la borne 7a le signal S5, limiter l'amplitude de ce signal pour en éliminer toute composante en modulation d'amplitude AM et, en réponse, fournir le signal S6 par la borne 7b.

En se référant à nouveau à la figure 4, l'étage de démodulation FM 8 comprend une borne d'entrée 8a connectée à la borne de sortie 7b de l'amplificateur/limiteur 7, et une borne de sortie 8b connectée à un amplificateur audio (non représenté en figure 4). L'étage de démodulation FM 8 est agencé pour pouvoir recevoir par la borne 8a le signal S6, démoduler ce signal et, en réponse, fournit un signal électrique S7 représentant le signal S6 démodulé.

On note qu'un mode de réalisation de l'étage de démodulation 8 est décrit dans le brevet US 5.808.510.

L'étage AFC 36 comprend une borne d'entrée 36a connectée à la borne de sortie 7b de l'amplificateur/limiteur 7, et une borne de sortie 36c connectée à la borne d'entrée 5b de l'oscillateur local 5. L'étage AFC 36 est agencé pour permettre d'opérer un accord fin entre la fréquence f_{LO} du signal S3 de l'oscillateur local 5, afin de maintenir constante la fréquence intermédiaire fIF du signal démodulé S7, comme cela est décrit de façon plus détaillée ci-après.

Le récepteur FM 29 comprend en outre une boucle de verrouillage 32 agencée pour asservir la fréquence intermédiaire f_{IF} à partir de la fréquence pilote fp. On rappelle qu'une telle fréquence est toujours disponible dans un signal multiplex FM, et permet de reconstituer la porteuse supprimée dans un récepteur à modulation de fréquence stéréophonique. Dans le cadre de la présente description, la fréquence fp est présente dans le signal S7, et typiquement est égale à 19 kHz.

A cet effet, la boucle de verrouillage 32 comprend un filtre de boucle à phase asservie (PLL) 34 et l'étage AFC 36.

Le filtre 34 comprend une borne d'entrée 34a connectée à la borne de sortie 8b de l'étage de démodulation 8, et une borne de sortie 34b connectée à l'étage AFC 36. Le filtre 34 est agencé pour recevoir par la borne 34a le signal S7 et, en réponse, fournir par la borne 34b un signal électrique S8 ayant une fréquence sensiblement égale à la fréquence pilote fp.

Le filtre 34 peut être réalisé à partir d'une boucle à phase asservie (PLL) ayant une largeur de bande déterminée de manière à pouvoir fournir le signal à la fréquence pilote fp et avec un rapport signal sur bruit (SNR) élevé. Ceci permet de fournir une fréquence de référence stable, susceptible de réaliser la fonction AFC, sans qu'il soit nécessaire de recourir à des moyens supplémentaires pouvant fournir une fréquence de référence.

L'étage AFC 36 comprend en outre une borne d'entrée 36b connectée à la borne de sortie 34b du filtre 34. L'étage AFC 36 est agencé pour pouvoir recevoir le signal S6 à la fréquence intermédiaire f_{IF} et le signal S8 à la fréquence pilote fp et, en réponse, fournir un signal électrique S9 propre à commander l'oscillateur local 5 (c'est-à-dire la fourniture du signal S3 à la fréquence f_{LO}) de sorte que la fréquence intermédiaire f_{IF} a une valeur moyenne asservie sur une valeur prédéterminée, comme cela est décrit ci-après.

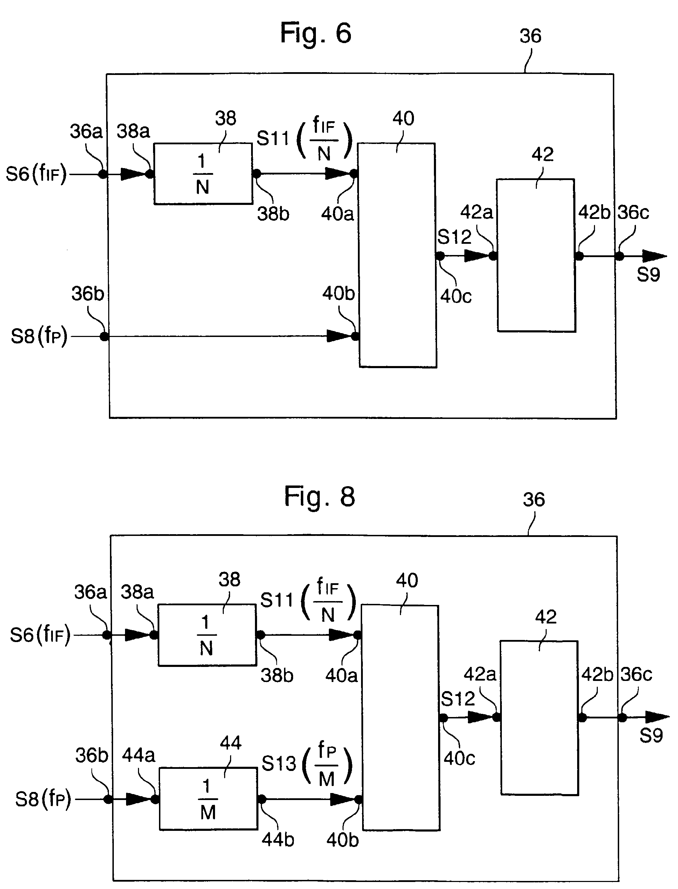

La figure 6 représente de façon détaillée un mode de réalisation de l'étage AFC 36 qui comprend un premier diviseur de fréquence 38, un comparateur de fréquence et de phase 40 et un filtre de boucle 42.

Le diviseur 38 comprend une borne d'entrée 38a connectée à la borne d'entrée 36a de l'étage AFC 36, et une borne de sortie 38b connectée au comparateur 40. Le diviseur 38 est agencé pour pouvoir recevoir par la borne 38a le signal S6 à la fréquence f_{IF} et, en réponse, fournir par la borne 38b un signal électrique S11 à une fréquence égale à : f_{IF}/N, N étant un nombre entier.

Le comparateur 40 comprend une borne d'entrée 40a connectée à la borne de sortie 38b du diviseur 38, une borne d'entrée 40b connectée à la borne d'entrée 36b de l'étage AFC 36, et une borne de sortie 40c connectée au filtre 42. Le comparateur 40 est agencé pour pouvoir recevoir par les bornes 40a et 40b le signal S11 à la fréquence f_{IF}/N et le signal S8 à la fréquence pilote fp, comparer les signaux S11 et S8 entre eux et, en réponse, fournir par la borne 40c un signal d'erreur S12 qui est proportionnel à la différence de fréquence entre les fréquences f_{IF}/N et fp.

Le filtre 42 comprend une borne d'entrée 42a connectée à la borne de sortie 40c du comparateur 40, et une borne de sortie 42b connectée à la borne de sortie 36c de l'étage AFC 36. Le filtre 42 est agencé pour recevoir par la borne 42a le signal S12 et, en réponse, fournir par la borne 42b le signal S9 représentatif de la différence entre les fréquences f_{IF}/N et fp.

Pour l'essentiel, en se référant aux figures 4 à 6, quand la boucle 32 est verrouillée, la fréquence intermédiaire f_{IF} a alors une valeur moyenne qui est sensiblement égale à : N-fp, cette valeur correspondant à ladite valeur prédéterminée qui permet de décoder les signaux contenant les données RDS.

On va maintenant décrire, à titre d'exemple uniquement, trois cas représentatifs de trois plages de fréquence dans lesquelles ladite valeur prédéterminée peut être choisie de manière à permettre le décodage des signaux contenant les données RDS. Ces trois cas seront décrits en se référant à nouveau à la figure 2, et en relation avec les figures respectives 7A à 7C qui représentent les répartitions spectrales des signaux contenant les données RDS et de la fréquence f_{IF,} pour trois valeurs prédéterminées différentes, respectivement.

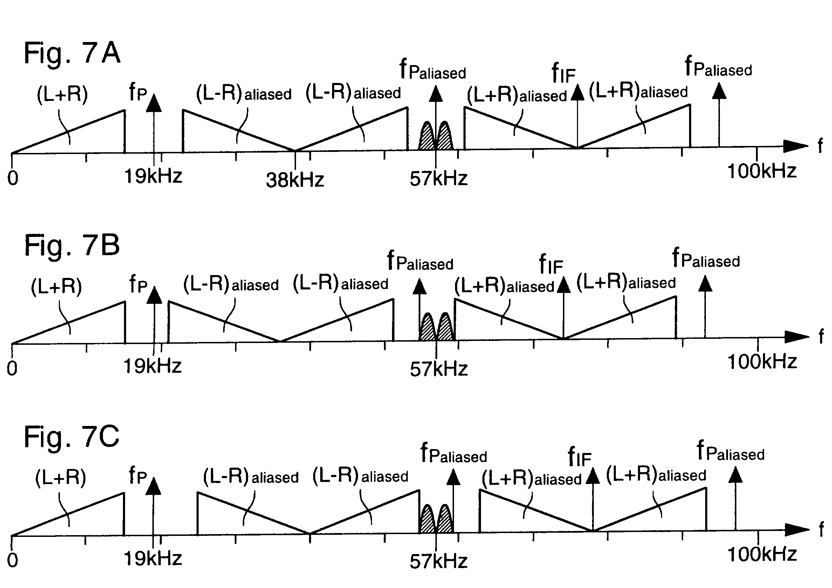

En se référant à la figure 7A, considérons le premier cas où ladite valeur prédéterminée est choisie de sorte que la fréquence fIF est asservie sur 76 kHz, en reprenant les valeurs citées en relation avec la figure 2.

En se référant à la figure 7B, considérons le deuxième cas où ladite valeur prédéterminée est choisie de sorte que la fréquence f_{IF} est comprise entre 72 et 73,5 kHz, en reprenant les valeurs citées en relation avec la figure 2.

En se référant à la figure 7C, considérons le troisième cas où ladite valeur prédéterminée est choisie de sorte que la fréquence fIF est comprise entre 78,5 et 80 kHz, en reprenant les valeurs citées en relation avec la figure 2.

Ainsi, dans les trois cas susmentionnés, il n'y a pas de recouvrement entre la répartition spectrale des signaux contenant les données RDS et celles des données audio, de sorte que le phénomène de repliement de spectre n'empêche pas la démodulation des signaux contenant les données RDS.

Il va de soi pour l'homme du métier que la description ci-dessus peut subir diverses modifications sans sortie du cadre de la présente invention.

A titre de perfectionnement, et en se référant à nouveau à la figure 4, le récepteur 29 peut comprendre un étage à haute fréquence (RF) 3. comprenant une borne d'entrée 3a connectée à la borne de sortie 2a de l'antenne 2, et une borne de sortie 3b connectée au bloc mélangeur 30. L'étage RF 3 est agencé pour pouvoir recevoir par la borne 3a le signal S1 et, en réponse, fournir par la borne 3b un signal électrique S2 amplifié ayant une fréquence comprise dans une bande de fréquence centrée sur une fréquence porteuse fc d'un émetteur prédéterminé.

Un avantage d'un tel agencement de l'étage RF 3 est de pouvoir augmenter la sensibilité du récepteur 29, se sorte que ce dernier peut alors fonctionner avec des signaux RF de faible amplitude.

A titre de perfectionnement également, et en se référant à nouveau à la figure 4, le récepteur 29 peut comprendre un filtre de boucle à fréquence asservie (FLL) 31 comprenant une borne d'entrée 3la connectée à la borne de sortie 8b de l'étage de démodulation 8, pour recevoir le signal S7, et une borne de sortie 31b connectée à la borne d'entrée 5a de l'oscillateur local 5, pour fournir un signal S10.

Un avantage d'un tel agencement du filtre FLL 31 est de pouvoir diminuer la déviation du signal S6.

A titre de perfectionnement également, et en se référant à la figure 8, l'étage AFC 36 peut comprendre en outre un deuxième diviseur de fréquence 44. On note en figure 8 que des objets similaires à ceux de la figure 6 ont été désignés par les mêmes références.

Comme le représente la figure 8, le diviseur 44 comprend une borne d'entrée 44a connectée à la borne d'entrée 36b de l'étage AFC 36, et une borne de sortie 44b connectée à la borne d'entrée 40b du comparateur 40. Le diviseur 44 est agencé pour pouvoir recevoir par la borne 44a le signal S8 à la fréquence pilote fp et, en réponse, fournir par la borne 44b un signal électrique S13 à une fréquence égale à : fp/M, M étant un nombre entier.

Pour l'essentiel, en se référant aux figures 4 et 8, quand la boucle 32 est verrouillée, la fréquence intermédiaire f_{IF} a alors une valeur moyenne qui est sensiblement égale à : N/M·fp.

Un avantage d'un tel agencement du diviseur 44 est d'augmenter la résolution de la boucle de verrouillage 32. A titre d'exemple, dans le cas où M=19, la fréquence intermédiaire f_{IF} peut être alors ajustée par des sauts de 1 kHz.

## Revendications

1. Récepteur (29) à modulation de fréquence pouvant recevoir d'un émetteur un signal à une fréquence élevée, ce récepteur comprenant:
- une antenne (2) pouvant, en réponse audit signal reçu, fournir un premier signal électrique (S1) représentatif dudit signal reçu;
- un étage à haute fréquence (3) pouvant, en réponse audit premier signal, fournir un deuxième signal électrique (S2) amplifié par rapport audit premier signal, et à une fréquence comprise dans une bande de fréquence centrée sur une fréquence porteuse (fc) dudit émetteur;
- un oscillateur (5) pouvant, en réponse à un signal de commande (S9), fournir un troisième signal électrique (S3);
- un bloc mélangeur (30) pouvant, en réponse auxdits deuxième et troisième signaux, fournir le produit de ces signaux sous la forme d'un quatrième signal électrique (S6) à une fréquence intermédiaire (f_{IF});
- un étage de démodulation FM (8) pouvant, en réponse audit quatrième signal (S6), démoduler ce signal et fournir le résultat sous la forme d'un cinquième signal électrique (S7); et
- un étage de commande automatique de fréquence (36) pouvant, en réponse audit cinquième signal (S7), fournir ledit signal de commande (S9) audit oscillateur, de manière à maintenir constante ladite fréquence intermédiaire (f_{IF}) dudit cinquième signal (S7),
ce récepteur étant caractérisé en ce qu'il comprend en outre une boucle de verrouillage (32) agencée pour asservir ladite fréquence intermédiaire (f_{IF}) à partir d'une fréquence pilote (fp) présente dans ledit cinquième signal (S7).

2. Récepteur (29) selon la revendication 1, caractérisé en ce que ladite boucle de verrouillage (32) comprend:
- un filtre de boucle à phase asservie (34) pouvant, en réponse audit cinquième signal (S7), fournir un sixième signal électrique (S8) à ladite fréquence pilote (fp);
- ledit étage de commande automatique de fréquence (36) pouvant, en réponse audit quatrième signal (S6) à ladite fréquence intermédiaire (f_{IF}) et audit sixième signal (S8) à ladite fréquence pilote (fp), fournir ledit signal de commande (S9) de sorte que ladite fréquence intermédiaire (f_{IF}) a une valeur moyenne asservie à une valeur prédéterminée dépendant de ladite fréquence pilote (fp).

3. Récepteur (29) selon la revendication 2, caractérisé en ce que ledit filtre de boucle à phase asservie (34) est formé pour avoir une largeur de bande déterminée, de manière à pouvoir fournir ledit sixième signal (S8) à ladite fréquence pilote (fp) et avec un rapport signal sur bruit élevé.

4. Récepteur (29) selon la revendication 1, caractérisé en ce que ledit étage de commande automatique de fréquence (36) comprend un premier diviseur de fréquence (38) pouvant, en réponse audit quatrième signal (S6) à ladite fréquence intermédiaire (f_{IF}), fournir un septième signal électrique (S11) à une première fréquence (f_{IF}/N) égale à ladite fréquence intermédiaire divisée par un premier nombre entier (N).

5. Récepteur (29) selon la revendication 4, caractérisé en ce que ledit étage de commande automatique de fréquence (36) comprend en outre un comparateur de fréquence et de phase (40) pouvant, en réponse audit septième signal (S11) à ladite première fréquence (f_{IF}/N) et audit sixième signal (S8) à ladite fréquence pilote (fp), fournir un huitième signal électrique (S12) représentatif de la différence entre ladite première fréquence (f_{IF}/N) et ladite fréquence pilote (fp).

6. Récepteur (29) selon la revendication 5, caractérisé en ce que ledit étage de commande automatique de fréquence (36) comprend en outre un filtre de boucle (42) pouvant, en réponse audit huitième signal (S12), fournir ledit signal de commande (S9) représentatif de la différence entre ladite première fréquence (f_{IF}/N) et ladite fréquence pilote (fp), de sorte que ladite fréquence intermédiaire (f_{IF}) a une valeur moyenne asservie sur une valeur prédéterminée (N·fp).

7. Récepteur (29) selon la revendication 4, caractérisé en ce que ledit étage de commande automatique de fréquence (36) comprend en outre :
- un deuxième diviseur de fréquence (44) pouvant, en réponse audit sixième signal (S8) à ladite fréquence pilote (fp), fournir un neuvième signal électrique (S13) à une deuxième fréquence (fp/M) égale à ladite fréquence pilote (fp) divisée par un deuxième nombre entier (M); et
- un comparateur de fréquence et de phase (40) pouvant, en réponse audit septième signal (S11) à ladite première fréquence (f_{IF}/N) et audit neuvième signal (S13) à ladite deuxième fréquence (fp/M), fournir un huitième signal électrique (S12) représentatif de la différence entre lesdites première et deuxième fréquences.

8. Récepteur (29) selon la revendication 7, caractérisé en ce que ledit étage de commande automatique de fréquence (36) comprend en outre un filtre de boucle (42) pouvant, en réponse audit huitième signal (S12), fournir ledit signal de commande (S9) représentatif de la différence entre ladite première fréquence (f_{IF}/N) et ladite deuxième fréquence (fp/M), de sorte que ladite fréquence intermédiaire (f_{IF}) a une valeur moyenne asservie sur une deuxième valeur prédéterminée (N/M·fp).

9. Récepteur (29) selon la revendication 1, caractérisé en ce que ladite boucle de verrouillage (32) comprend en outre un filtre de boucle à fréquence asservie (31) agencé pour recevoir ledit cinquième signal (S7) et fournir en réponse un dixième signal électrique (S10) audit oscillateur (5), de manière à pouvoir diminuer la déviation dudit quatrième signal (S6).

10. Récepteur (29) selon la revendication 1, caractérisé en ce que ledit bloc mélangeur (30) comprend, connectés en série, un mélangeur (4), un filtre à fréquence intermédiaire (6) et un amplificateur/limiteur (7).

11. Récepteur (29) selon la revendication 1, caractérisé en ce que ladite fréquence pilote (fp) est égale à 19 kHz.

## Revendications modifiées

### Revendications modifiées conformément à la règle 86(2) CBE.

**1.** Récepteur (29) à modulation de fréquence pouvant recevoir d'un émetteur un signal à une fréquence élevée, ce récepteur comprenant:
- une antenne (2) pouvant, en réponse audit signal reçu, fournir un premier signal électrique (S1) représentatif dudit signal reçu;
- un étage à haute fréquence (3) pouvant, en réponse audit premier signal, fournir un deuxième signal électrique (S2) amplifié par rapport audit premier signal, et à une fréquence comprise dans une bande de fréquence centrée sur une fréquence porteuse (fc) dudit émetteur;
- un oscillateur (5) pouvant, en réponse à un signal de commande (S9), fournir un troisième signal électrique (S3);
- un bloc mélangeur (30) pouvant, en réponse auxdits deuxième et troisième signaux, fournir le produit de ces signaux sous la forme d'un quatrième signal électrique (S6) à une fréquence intermédiaire (f_{IF}); et
- un étage de démodulation FM (8) pouvant, en réponse audit quatrième signal (S6), démoduler ce signal et fournir le résultat sous la forme d'un cinquième signal électrique (S7);
ce récepteur étant caractérisé en ce qu'il comprend en outre une boucle de verrouillage (32) agencée pour asservir ladite fréquence intermédiaire (f_{IF}) à partir d'une fréquence pilote (fp) présente dans ledit cinquième signal (S7), ladite boucle de verrouillage (32) comprenant un étage de commande automatique de fréquence (36) pouvant, en réponse audit cinquième signal (S7), fournir ledit signal de commande (S9) audit oscillateur, de manière à maintenir constante la fréquence intermédiaire (f_{IF}) dudit quatrième signal (S6).

**2.** Récepteur (29) selon la revendication 1, caractérisé en ce que ladite boucle de verrouillage (32) comprend en outre :
- un filtre de boucle à phase asservie (34) pouvant, en réponse audit cinquième signal (S7), fournir un sixième signal électrique (S8) à ladite fréquence pilote (fp);
ledit étage de commande automatique de fréquence (36) pouvant, en réponse audit quatrième signal (S6) à ladite fréquence intermédiaire (f_{IF}) et audit sixième signal (S8) à ladite fréquence pilote (fp), fournir ledit signal de commande (S9) de sorte que ladite fréquence intermédiaire (f_{IF}) a une valeur moyenne asservie à une valeur prédéterminée dépendant de ladite fréquence pilote (fp).

**3.** Récepteur (29) selon la revendication 2, caractérisé en ce que ledit filtre de boucle à phase asservie (34) est formé pour avoir une largeur de bande déterminée, de manière à pouvoir fournir ledit sixième signal (S8) à ladite fréquence pilote (fp) et avec un rapport signal sur bruit élevé.

**4.** Récepteur (29) selon la revendication 2, caractérisé en ce que ledit étage de commande automatique de fréquence (36) comprend :
- un premier diviseur de fréquence (38) pouvant, en réponse audit quatrième signal (S6) à ladite fréquence intermédiaire (f_{IF}), fournir un septième signal électrique (S11) à une première fréquence (f_{IF}/N) égale à ladite fréquence intermédiaire divisée par un premier nombre entier (N);
- un comparateur de fréquence et de phase (40) pouvant, en réponse audit septième signal (S11) à ladite première fréquence (f_{IF}/N) et audit sixième signal (S8) à ladite fréquence pilote (fp), fournir un huitième signal électrique (S12) représentatif de la différence entre ladite première fréquence (f_{IF}/N) et ladite fréquence pilote (fp); et
- un filtre de boucle (42) pouvant, en réponse audit huitième signal (S12), fournir ledit signal de commande (S9) représentatif de la différence entre ladite première fréquence (f_{IF}/N) et ladite fréquence pilote (fp), de sorte que ladite fréquence intermédiaire (f_{IF}) a une valeur moyenne asservie sur une valeur prédéterminée (N·fp) égale au produit de ladite fréquence pilote (fp) par ledit premier nombre entre (N).

**5.** Récepteur (29) selon la revendication 2, caractérisé en ce que ledit étage de commande automatique de fréquence (36) comprend :
- un premier diviseur de fréquence (38) pouvant, en réponse audit quatrième signal (S6) à ladite fréquence intermédiaire (f_{IF}), fournir un septième signal électrique (S11) à une première fréquence (f_{IF}/N) égale à ladite fréquence intermédiaire divisée par un premier nombre entier (N);
- un deuxième diviseur de fréquence (44) pouvant, en réponse audit sixième signal (S8) à ladite fréquence pilote (fp), fournir un neuvième signal électrique (S13) à une deuxième fréquence (fp/M) égale à ladite fréquence pilote (fp) divisée par un deuxième nombre entier (M);
- un comparateur de fréquence et de phase (40) pouvant, en réponse audit septième signal (S11) à ladite première fréquence (f_{IF}/N) et audit neuvième signal (S13) à ladite deuxième fréquence (fp/M), fournir un huitième signal électrique (S12) représentatif de la différence entre lesdites première et deuxième fréquences; et
- un filtre de boucle (42) pouvant, en réponse audit huitième signal (S12), fournir ledit signal de commande (S9) représentatif de la différence entre ladite première fréquence (f_{IF}/N) et ladite deuxième fréquence (fp/M), de sorte que ladite fréquence intermédiaire (f_{IF}) a une valeur moyenne asservie sur une valeur prédéterminée (N/M·fp) égale au produit de ladite fréquence pilote (fp) par ledit premier nombre entier (N) divisé par ledit deuxième nombre entier (M).

**6.** Récepteur (29) selon la revendication 1, caractérisé en ce que ladite boucle de verrouillage (32) comprend en outre un filtre de boucle à fréquence asservie (31) agencé pour recevoir ledit cinquième signal (S7) et fournir en réponse un dixième signal électrique (S10) audit oscillateur (5), de manière à pouvoir diminuer la déviation dudit quatrième signal (S6).

**7.** Récepteur (29) selon la revendication 1, caractérisé en ce que ledit bloc mélangeur (30) comprend, connectés en série, un mélangeur (4), un filtre à fréquence intermédiaire (6) et un amplificateur/limiteur (7).

**8.** Récepteur (29) selon la revendication 1, caractérisé en ce que ladite fréquence pilote (fp) est égale à 19 kHz.
